# EUROPÄISCHE PATENTANMELDUNG

(11) **EP 1 296 152 A1**
(43) Veröffentlichungstag der Anmeldung: **26.03.2003**
(21) Anmeldenummer: 01122773.3
(22) Anmeldetag: 21.09.2001
(51) Int. Cl.: G01R 31/3185

(54) **Elektronischer Baustein und Verfahren zu dessen Qualifizierungsmessung**

(71) Anmelder: SIEMENS AKTIENGESELLSCHAFT, 80333 München (DE)
(72) Erfinder: Eppensteiner, Friedrich, 1130 Wien (AT); Ghameshlu, Majid, 1110 Wien (AT); Krause, Karlheinz, 82152 Planegg (DE)

(57) **Zusammenfassung**

Um bei einem Elektronischer Baustein (1) mit integrierter Halbleiterschaltung, die einen Core (2) mit funktionalen Flip-Flops aufweist, wobei ein Teil der funktionalen Flip-Flops als Eingangs-FFs (7) mit Eingangspins (3) des Bausteins (1) verbunden sind, und wobei ein Teil der funktionalen Flip-Flops als Ausgangs-FFs (8) mit Ausgangspins (6) des Bausteins (1) verbunden sind, effiziente, kostengünstige und schnell durchgeführte ASIC Qualifikationsmethoden vorzusehen, die gleichzeitig den immer komplexer werdenden integrierten Schaltungen und den immer kürzer werdenden Technologiesprüngen Rechnung tragen, sieht die vorliegende Erfindung ein Verfahren und eine Vorrichtung vor, bei dem die Eingangs-FFs (7) und die Ausgangs-FFs (8) während einer Qualifizierungsmessung des Bausteins (1) zu einem Schieberegister zusammenschaltbar sind.

## Beschreibung

Die Erfindung bezieht sich auf einen elektronischen Baustein mit integrierter Halbleiterschaltung, die einen Core mit funktionalen Flip-Flops aufweist, wobei ein Teil der funktionalen Flip-Flops als Eingangs-FFs mit Eingangspins des Bausteins verbunden sind, und wobei ein Teil der funktionalen Flip-Flops als Ausgangs-FFs mit Ausgangspins des Bausteins verbunden sind, sowie auf ein Verfahren zu dessen Qualifizierungsmessung.

Elektrische Bausteine dieser Art werden häufig als Application Specific Integrated Circuits (ASICs) ausgebildet, die nach ihrer Herstellung umfangreichen Qualifizierungsverfahren unterzogen werden. ASICs sind eine Ansammlung von Schaltungen mit einfachen Funktionen, wie Flip-Flops, Invertierern, NANDs und NORs, sowie von komplexeren Strukturen wie Speicheranordnungen, Addierern, Zählern und Phasenregelschleifen. Die verschiedenen Schaltungen werden in einem ASIC kombiniert, um eine bestimmte Anwendung durchzuführen. Hierbei werden ASICs in einer Vielzahl von Produkten, wie zum Beispiel Konsumprodukten, wie Videospielen, digitale Kameras, in Fahrzeugen und PCs, sowie in High-End Technologie Produkten, wie Workstations und Supercomputern eingesetzt.

Bekannte ASIC-Architekturen umfaßen einen ASIC-Core, in dem die verschiedenen Schaltungselemente, die die Funktion des ASICs bilden, aufgenommen sind. Der ASIC-Core erhält die zu verarbeitenden Eingaben von Input-Treibern. Nach der Verarbeitung durch den ASIC-Core werden die Ausgabedaten über Output-Treiber ausgegeben.

Um die Funktionalität des ASICs zu überprüfen, sind verschiedene "Design for test" (DFT)-Verfahren bekannt. Der Vorteil von DFT-Verfahren liegt darin, daß bereits bei der Konstruktion des Chips Schaltungselemente eingefügt werden, was ein späteres scan-basiertes Testen ermöglicht, die Anzahl der benötigten Testpunkte auf dem Board des ASICs reduziert und zugleich das Problem von nicht vorhandenen Zugriffspunkten auf dem Chip umgeht.

Bei bekannten Qualifikationsmethoden bzw. Prüfmethoden werden umfangreiche Testvektoren erstellt. Diese Testvektoren werden dann in einen ASIC eingegeben, mit dem Ziel, bestimmte Ausgänge des ASICs zum Ändern des logischen Zustands zu bewegen. Bei der Zustandsänderung der Ausgänge kann dann der sogenannte "Clock-to-Output Delay" gemessen werden, welcher die Verzögerung zwischen der erfolgten Taktung und der Ausgabe am Ausgang des ASIC wiedergibt. Für die Eingangsbereiche eines ASICs wird mit Hilfe von Qualifizierungsverfahren eine ggf. vorhandene Verletzung des Timings, d.h. der SETUP- und HOLD-Zeit (siehe unten) bestimmt, und am Ausgang des ASICs signalisiert.

Damit die Ausgabe eines Flip Flops vorhersehbar, d.h. nicht metastabil ist, müssen die Eingaben am Flip Flop innerhalb der SETUP- und HOLD-Zeitanforderung des Flip Flops liegen. Bei der SETUP-Zeit handelt es sich um die Zeitperiode vor der Anstiegsflanke der Synchronisierungstaktung. Mit der HOLD-Zeit wird die Zeitperiode nach der Anstiegsflanke der Synchronisierungstaktung bezeichnet. Wenn die SETUP- und HOLD-Zeitkriterien des Flip Flops nicht erfüllt werden, ist die Ausgabe des Flip Flops nicht sicher gewährleistet. Daher ist eine genaue Bestimmung der SETUP- und HOLD-Zeit von großer Bedeutung.

Der Aufwand zum Erstellen von Testvektoren für oben beschriebene Qualifizierungsverfahren ist beträchtlich, da die Testvektoren zum Teil manuell generiert werden. Weiterhin ist eine Kenntnis der Funktion des Cores des ASICs nötig.

Zudem ist es erforderlich, den Anforderungen der Testeinrichtung zu entsprechen, d.h. es könnte notwendig sein, den Testdurchlauf anzuhalten, da wegen der begrenzten Speichertiefe ein Nachladen der Testvektoren erforderlich ist.

Die Meßverfahren zum Qualifizieren des ASICs werden zudem durch Faktoren wie hoher Pincount, Komplexität bzw. logische Tiefe, interne Phasenregelschleifen (PLLs) und logische Power-Up-Sequenzen des ASICs erschwert. Hierbei werden die oben angeführten Faktoren in Zukunft die Qualifizierung des ASICs noch erschweren.

Der in Patentanspruch 1 angegebenen Erfindung liegt daher das Problem zugrunde, einen elektronischen Baustein zu schaffen und ein Qualifizierungsverfahren aufzuzeigen, der bzw. das eine effiziente, kostengünstige und schnell durchführbare ASIC Qualifikationsmethode vorsieht, sowie gleichzeitig den immer komplexer werdenden integrierten Schaltungen und den immer kürzer werdenden Technologiesprüngen Rechnung trägt.

Diese Aufgabe wird durch einen elektronischen Baustein gemäß Patentanspruch 1 gelöst, bei dem die Eingangs-FFs und die Ausgangs-FFs während einer Qualifizierungsmessung des Bausteins zu einem Schieberegister zusammenschaltbar sind.

Hierbei ergeben sich folgende Vorteile:
- Es müssen lediglich verhältnismäßig kurze Testvektoren für die Timingmessung eingesetzt werden.
- Es ergeben sich kurze Testzeiten unabhängig von der logischen Tiefe des zu testenden ASICs.
- Die Testvektoren können aus einer dem Boundery Scan Discription Language File (BDSL File) ähnlichen Datenbasis automatisch erzeugt werden.
- Meßteams müssen sich weit weniger als bisher mit der Funktion des ASICs auseinandersetzen.

Gemäß einer weiteren vorteilhaften Ausführungsform der vorliegenden Erfindung weisen die Eingangs-FFs und die Ausgangs-FFs jeweils an ihren Eingängen ein Schaltelement auf, und werden mittels dieser durch Ansteuerung über eine für alle Schaltelemente zentrale Steuerung zusammengeschaltet. Dadurch wird der Vorbereitungsaufwand für Timingmessungen am ASIC erheblich reduziert

Bei einer besonders vorteilhaften Ausführungsform ist die Qualifizierungsmessung eine Setup- und/oder eine Hold-Messung an den Eingangs-FFs, wodurch die Timingmessungen durchgeführt werden können, ohne den Central-Core in Betrieb nehmen zu müssen, und bestimmte Ein- und Ausgänge der integrierten Schaltung trotz der logischen Tiefe mittels Testvektoren erfaßt werden, um eine Setup- und Hold-Zeitmessung bei den Eingängen zu ermöglichen.

Bei einer weiteren vorteilhaften Ausführungsform ist die Qualifizierungsmessung eine Clock-to-output-Zeitmessung an den Ausgangs-FFs und/oder den Ausgängen des Bausteins, wodurch die Timingmessungen durchgeführt werden können, ohne den Central-Core in Betrieb nehmen zu müssen, und bestimmte Ausgänge der integrierten Schaltung trotz der logischen Tiefe mittels Testvektoren erfaßt werden, um eine Bestimmung der Clock-to-Output Delay bei den Ausgängen zu ermöglichen.

Bei einem anderen bevorzugten Ausführungsbeispiel der Erfindung ist die Qualifizierungsmessung eine Enable-to-output-Zeitmessung an den Ausgangs-FFs (8) und/oder den Ausgängen des Bausteins (1) ist, wodurch die Umschaltgeschwindigkeit der Tristate-Buffers gemessen werden kann.

Bei einer anderen vorteilhaften Ausführungsform sind die Schaltelemente Multiplexer, was einen nur geringfügiger Aufwand in der Hardware bedeutet.

Bei einem anderen vorteilhaften Ausführungsbeispiel verbinden die jeweiligen Schaltelemente bei der Qualifizierungsmessung den Ausgang eines Eingangs-FFs bzw. Ausgangs-FFs mit dem Eingang eines benachbarten Eingangs-FFs bzw. Output-FF, um das Schieberegister auf besonders einfache Weise herzustellen.

Bei einem anderen vorteilhaften Ausführungsbeispiel erhalten alle Eingangs- und Ausgangs-FFs über einen Taktbaum bei der Qualifizierungsmessung dieselbe Taktung. Damit liegt bei den Timingmessungen eine reale Taktung vor und der für die Messung wichtige Taktbaum und die PLLs werden in den Timingmessungen berücksichtigt.

Bei einem weiteren vorteilhaften Ausführungsbeispiel erhalten die Eingangs- und/oder Ausgangs-FFs über einen Taktbaum eine unterschiedliche Taktung um Qualifizierungsmessungen bei einem ASIC mit verschiedenen Taktdomänen vorzusehen.

Bei einem besonders vorteilhaften Ausführungsbeispiel weist die Steuerung einen ersten Pin zur Steuerung der Schaltelemente, einen zweiten Pin zur Steuerung der unidirektionalen Outputpuffer und einen dritten Pin zur Steuerung der bidirektionalen Outputpuffer auf, um das Schieberegister und die Steuerung der Ausgangspuffer bei dem Qualifizierungsverfahren separat bzw. zusätzlich zu einer Steuerung durch andere Testverfahren, wie dem Fertigungstest, oder einer Steuerung durch den Core selbst vorzusehen.

Bei einem alternativen vorteilhaften Ausführungsbeispiel weist die Steuerung eine Vielzahl von Gattern auf, um bei dem erfindungsgemäßen Qualifizierungsverfahren eine Maskierung von Steuerungen durch andere Testverfahren, wie dem Fertigungstest, oder einer Steuerung durch den Core selbst vorzusehen.

Bei der erfindungsgemäßen Lösung des Problems durch Vorsehen eines Verfahrens zur Qualifizierungsmessung eines elektrischen Bausteins gemäß Anspruch 12, bei dem die Eingangs-FFs und die Ausgangs-FFs während einer Qualifizierungsmessung des Bausteins zu einem Schieberegister zusammengeschaltet werden, ergeben sich die selben Vorteile wie bezüglich der oben beschriebenen Vorrichtung.

Bei einem Ausführungsbeispiel des erfindungsgemäßen Verfahrens, bei dem die Testdaten über Eingänge des Bauelements parallel in die Eingangs-FF eingegeben und danach die Steuerung die Eingangs-FFs und die Ausgangs-FFs zum Schieberegister zusammenschaltet werden, wobei danach die Testdaten seriell das Schieberegister durchlaufen und über einen Ausgang ausgelesen werden, ergibt sich der weitere Vorteil, daß Timingmessungen im Eingangsbereich durchgeführt werden können, ohne den Central-Core in Betrieb nehmen zu müssen.

Bei einem weiteren Ausführungsbeispiel des erfindungsgemäßen Verfahrens wird durch zeitliche Variation der Dateneingabe in die Eingangs-FF relativ zur Taktung und durch Verifizierung der ausgelesenen Testdaten die Setup- und Holdzeit bestimmt, was eine genaue Präzisierung der Setup- und Hold-Kriterien ermöglicht.

Bei einem anderen weiteren Ausführungsbeispiel des erfindungsgemäßen Verfahrens schaltet die Steuerung die Eingangs-FFs und die Ausgangs-FFs zu einem Schieberegister, wobei die Testdaten über einen Eingang des Bauelements seriell in einen Eingangs-FF eingeschoben werden, die Testdaten das Schieberegisters seriell durch ein Durchlaufen des Schieberegisters in die Ausgangs-FF gelangen, und während des Einschiebevorgangs der Daten in die Ausgangs-FFs an den entsprechenden Ausgängen des Bauteils die Clock-to-output-Zeiten gemessen werden. Dadurch ergibt sich der weitere Vorteil, daß Timingmessungen im Ausgangsbereich durchgeführt werden können, ohne das der Central-Core in Betrieb genommen werden muß.

Bei einem besonders vorteilhaften Ausführungsbeispiel des erfindungsgemäßen Verfahrens werden die Testdaten über die Eingänge des Bauelements parallel in die Eingangs-FF eingeschoben, wobei die Steuerung danach die Eingangs-FF und die Ausgangs-FF zu einem Schieberegister schaltet, die Testdaten seriell durch ein Durchlaufen des Schieberegisters in die Ausgangs-FF gelangen, und während des Einschiebevorgangs der Daten in die Ausgangs-FFs an den entsprechenden Ausgängen des Bauteils die Clock-to-output-Zeiten gemessen werden. Dadurch kann eine besonders schnelle Timingmessung im Ausgangsbereich des ASICs durchgeführt werden, ohne das der Central-Core in Betrieb genommen wird.

Bei einem anderem vorteilhaften Ausführungsbeispiel des erfindungsgemäßen Verfahrens wird bei der Enable-to-output-Zeitmessung im Ausgangsbereich ein Tristate-Buffer durch ein Flip-Flop (8d) des Schieberegisters gesteuert, wobei die in das Schieberegister seriell eingeschobenen Testvektordaten zur Steuerung dienen. Dies ermöglicht eine besonders einfach zu implementierende Enable-to-output-Zeitmessung.

Ein Ausführungsbeispiel der Erfindung ist in der Zeichnung dargestellt und wird im Folgenden näher beschrieben. Die einzige Figur der Anmeldung zeigt eine schematische Darstellung eines elektronischen Bausteins gemäß der vorliegenden Erfindung.

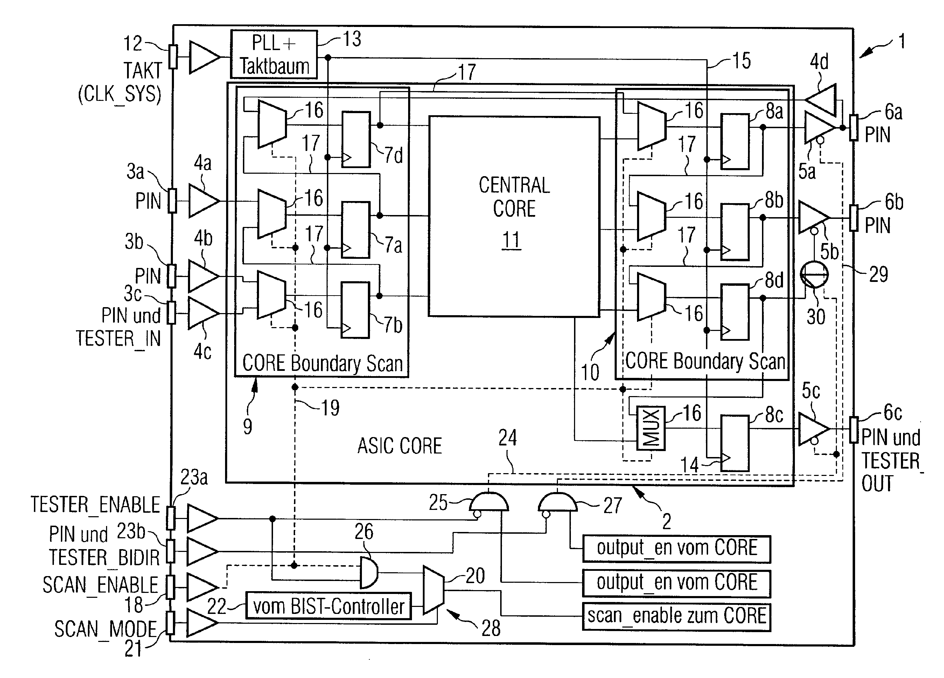

Die Fig. 1 zeigt einen elektronischen Baustein 1, genauer genommen einen Application Specific Integrated Circuit (ASIC) 1 mit einer Integrierten Schaltung (IC). Die IC umfaßt einen ASIC-Core 2, der Schaltungselemente wie Flip Flops, Invertierer, NANDs und NORs, etc. enthält. Die Anordnung der Schaltelemente im ASIC-Core 2 gewährleistet die spezifische Funktion des ASICs 1. Die von dem ASIC-Core 2 zu verarbeitenden Daten werden über Eingangspins 3a, 3b, 3c und jeweils nachgeschalteter Eingangspuffer 4a, 4b, 4c, 4d in den ASIC-Core 2 parallel eingegeben.

Nach der Verarbeitung durch den ASIC-Core 2 werden die verarbeiteten Daten parallel über unidirektionale Tristate-Output-Buffer 5a, 5b, 5c und jeweilige Ausgangspins 6a, 6b und 6c ausgeben. Die Tristate-Output-Buffer 5a, 5b, 5c können die logischen Zustände 1 und 0 sowie einen Hochimpedanzzustand Z einnehmen. Bei dem bevorzugten Ausführungsbeispiel der vorliegenden Erfindung, ist zumindest ein Pin 6a bidirektional, d.h. der Pin 6a kann durch ein Schalten des Tristate-Buffers 5a in den Zustand Z über dem Eingangsbuffer 4d als Eingangspin verwendet werden.

Für die jeweiligen Eingangs- und Ausgangspins 3, 6 existieren im ASIC-Core 2 entsprechende Eingangs-Flip Flops (Eingangs-FF) 7a, 7b, 7d und entsprechende Ausgangs-Flip Flops (Ausgangs-FF) 8a, 8b, 8c, 8d. Die Eingangs-FF 7a, 7b, 7d sind in zumindest einem Eingangsblock 9 und die Ausgangs-FF 8a, 8b, 8d sind in zumindest einem Ausgangsblock 10 angeordnet. Der ASIC-Core 2 unterteilt sich somit in zumindest drei Blöcke: den Eingangsblock 9, den Ausgangsblock 10 und einen Central-Core 11. Der Eingangsblock 9 und der Ausgangsblock 10 bilden zusammen den als Core-Boundary bezeichneten Teil des Cores 2.

Die Schaltungselemente des Eingangsblocks 9, des Ausgangsblocks 10 und des Central-Cores 11 gewähren zusammen die Funktion der IC des ASICs 1. Bei den Schaltungselementen handelt es sich um funktionale Flip-Flops (FF) und andere funktionale Elemente wie Inverter, NANDs und NORs, etc. Der Begriff "funktional" bezeichnet im folgenden Flip-Flops oder andere Schaltungselemente, die allein für den Betrieb des ASICS 1 und die Implementierung dessen anwendungsspezifischen Funktion benötigt werden. Solche Flip-Flops oder Schaltungselemente, die zusätzlich, z.B. lediglich und ausschließlich für die Durchführung von Testverfahren vorgesehen werden, fallen nicht unter diesen Begriff.

Im Normalbetrieb des ASICs 1 werden die Daten über die Eingangspins 3 eingegeben und parallel in den Eingangs-FF 7a, 7b, 7d des Eingangsblock 9 abgetaktet. Die Daten werden dann in den Central-Core 11 parallel weitergeleitet und weiterverarbeitet. Nach der Verarbeitung im Central-Core 11 werden die Daten parallel in den Ausgabeblock 10 gegeben, wo die Daten in den Ausgangs-FF 8a, 8b, 8d abgetaktet und weiter an die Ausgangspins 6a, 6b und 6c geliefert werden.

Der ASIC 1 hat einen Takteingang 12, der den ASIC-Core 2 über einen Taktbaum 13 taktet. Durch Einsatz von entsprechenden Phasenregelschleifen (PLLs) oder Delay-Elementen, werden der Central-Core 11 sowie die Blöcke 9, 10 getaktet (Takteingang für Central-Core nicht dargestellt). Jedes Eingangs-FF 7a, 7b, 7d und jedes Ausgangs-FF 8a, 8b, 8d wird über Taktanschlüsse 14 und Taktleitungen 15 getaktet.

Für die Durchführung einer Timingmessung in den Eingangsbereichen und den Ausgangsbereichen des ASICs 1 werden die Eingangs-FFs 7a, 7b, 7d zusammen mit den Ausgangs-FFs 8a, 8b, 8d zu einem Schieberegister konfiguriert. Dies wird ermöglicht durch Vorschalten von Multiplexern 16 am jeweiligen Eingang eines Eingangs-FF oder Ausgangs-FF 7, 8. Im Normalbetrieb des ASICs 1 schaltet der Multiplexer 16 die Eingaben über die Eingangspins 3a, 3b, 3c bzw. die Ausgaben des Central-Cores 11 in die Eingangs- und Ausgangs-FF 7,8.

Während der Timingmessung des ASICs schalten die Multiplexer 16 über Leitungen 17 die Eingangs-FF und Ausgangs-FFs zu einem Schieberegister bzw. zu einer Scankette (Core Boundary Scan) zusammen. Die Kette beginnt an dem Eingangspin 3c, der für das Testverfahren zum Eingangspin TESTER_IN wird und endet am letzten Ausgangs-FF 8c eines Ausganges 6c, der gleichzeitig als TESTER_OUT dient.

Die Multiplexer 16 können ggf. schon für die Durchführung des Fertigungstests entlang eines Scanpaths bzw. Scanpfades vorhanden sein. Bei dem Fertigungstest wird entlang von Scanpaths bzw. Untersuchungswegen die Funktionalität von Schaltungselemente im ASIC-Core 2 getestet.

Die Umschaltung des ASICs 1 in den Schiebemodus erfolgt wie beim Fertigungstest über einen SCAN_ENABLE Pin 18, der einen Teil einer Teststeuerung 28 bildet. Die Steuerung 28, die auch als Kombinatorik bezeichnet wird, steuert Schaltelemente des ASIC-Cores 2 sowie die unidirektionalen und bidirektionalen Puffer 5a, 5b und 5c, wenn Qualifizierungsverfahren an dem ASIC durchgeführt werden.

Wenn das Schieberegister gebildet werden soll, werden über ein an den SCAN_ENABLE Pin 18 angelegtes Signal über Scanleitungen 19 die Multiplexer 16 gesteuert. Da der SCAN_ENABLE Pin auch für den Fertigungstest eingesetzt wird, werden an den Pin 18 angelegte Signale auch über einen Multiplexer 20 der Steuerung 28, der von einem der Steuerung 28 zugeordneten Scan-Mode-Pin 21 gesteuert wird, zu anderen Abschnitten (nicht dargestellt) des ASIC-Cores 2 geführt. Dies geschieht, um "Scanpaths" bzw. Testpfade z.B. für den Fertigungstest im Core 2 zu schalten. Über den Multiplexer 20 könnten aber auch Steuerdaten von einem Built-in Selftest-Controller (BIST-Controller) 21 in den Core 2 eingegeben werden.

Zur Steuerung der unidirektionalen Tristate-Outputbuffer 5a, 5b, 5c weist die Steuerung 28 einen TESTER_ENABLE Pin 23a auf. Das Signal des TESTER_ENABLE Pins 23a wird zusammen mit eventuell vom Core vorhandenen Steuersignalen in ein erstes Gatter 25 der Steuerung 28 eingegeben. Das erste Gatter 25 ist im bevorzugten Ausführungsbeispiel ein AND-Gatter, wobei das Signal des TESTER_ENABLE Pins 23a am Eingang zum AND-Gatter 25 invertiert wird. Die Ausgabe des ersten Gatters 25 gelangt über eine Steuerleitung 24 zu den Tristate-Output-Buffern 5 und steuert deren Zustand. Gleichzeitig wird das Signal des TESTER_ENABLE Pins 23a über ein weiteres, zweites Gatter 27 der Steuerung 28 zusammen mit dem Signal des SCAN_ENABLE Pins 18 in den Multiplexer 20 und somit in den ASIC-Core 2 gegeben. Das zweite Gatter 26 ist im bevorzugten Ausführungsbeispiel wiederum ein AND-Gatter. Dadurch kann das Signal des SCAN_ENABLE Pins 18 in den ASIC-Core 2 mittels des TESTER_ENABLE Pins 23 maskiert bzw. verhindert werden.

Bei dem Qualifizierungstest der vorliegenden Erfindung werden die unidirektionalen ASIC Ausgänge eingeschaltet. Damit über das SCAN_ENABLE Signal des Pins 18 in den ASIC-Core 2 beim Qualifizierungstest keine Beeinflussung, sei es durch PLLs oder Delay-Elementen auftreten, wird wie oben erläutert das SCAN_ENABLE Signal in den ASIC-Core 2 bei dem Qualifizierungstest der vorliegenden Erfindung gesperrt.

Für das Steuern des zumindest einen bidirektionalen Pin 6a wird ein Pin TESTER_BIDIR 23b, als Teil des Steuerung 28, eingesetzt. Mit einem Signal an diesem Pin 23b wird gesteuert, ob der bidirektionale Pin 6a als Eingangs- oder Ausgangspin benutzt wird. Ähnlich wie beim TESTER_ENABLE Pin 23a, wird das Signal des TESTER_BIDIR Pins 23b zusammen mit eventuell vorhanden Steuersignalen des Cores 2 in ein drittes Gatter 27 gegeben. Bei dem dritten Gatter 27 handelt es sich im bevorzugten Ausführungsbeispiel um ein AND-Gatter und es wird, ähnlich wie beim ersten Gatter 25, das Signal des TESTER_BIDIR Pins 23b am Eingang des Gatters invertiert. Die Ausgabe des dritten Gatters 27 steuert über die Steuerleitung 29 den Zustand des bidirektionalem Tristate-Output-Buffers 5a.

Im Folgenden wird beschrieben, wie durch Einsatz des oben beschriebenen ASICs 1 Timingmessungen bzw. ein sogenannter Core-Boundary-Scan an den Eingangsbereichen und den Ausgangsbereichen des ASICs 1 durchgeführt wird.

### A) Messung der Clock-to-Output Zeit am Ausgang:

Zur Messung der Clock-to-Output Zeit, die auch als Clock-tooutput Delay bezeichnet wird, wird mittels des SCAN_ENABLE Pins 18 die Kette von Eingangs-FFs 7a,7b, 7d zusammen mit den Ausgangs-FFs 8a, 8b, 8d, 8c in den Schiebemodus gebracht. Der Testvektor bzw. das Testmuster für die Ausgänge wird seriell über den TESTER_IN Pin 3c eingeschoben. Der zumindest eine bidirektionale Pin 6a wurde über den TESTER_BIDIR Pin 23b in den Ausgangsmodus geschaltet. Während des Einschiebevorgangs des Testvektors, z.B. ein 0101-Muster, kann an den Ausgängen die Clock-to-Output Zeit gemessen werden. Die gemessenen Zeiten entsprechen denen im Normalbetrieb des ASICs 1.

Somit werden am Eingangspin 3c die Testvektordaten seriell in die Scankette bzw. das Schieberegister eingeschoben und am Ausgang parallel bewertet. Es ist zu erwähnen, daß für den Eingang nicht unbedingt ein eigener Pin 3c erforderlich ist, da bestimmte Eingänge mehrfach nutzbar sind.

### B) Messung der Umschaltgeschwindigkeit:

Die Messung der Umschaltgeschwindigkeit des Tristate-Buffers 5b des zumindest einen unidirektionalen Pins 6b von Z auf 1, von Z auf 0, von 0 auf Z und von 1 auf Z wird über ein zusätzlich implementiertes Flip Flop (FF) 8d im Schieberegister gewährleistet. Die Ansteuerung erfolgt über die am Eingangspin 3c seriell eingeschobenen Testvektordaten. Steuersignale des Flip Flop 8d oder Steuersignale vom Gatter 25 der Steuerung 25 werden über ein Gatter 30, das im bevorzugten Ausführungsbeispiel ein ODER-Gatter ist, an den Tristate-Buffer 5b geleitet.

Der gleiche Effekt kann auch bei bidirektionalen Pins durch die beschriebene Maßnahme erzielt werden.

### C) Messung von SETUP- und HOLD-Zeiten an den Eingängen:

Bei der Bestimmung der SETUP- und HOLD-Zeiten ist der zumindest eine bidirektionale Pin 6a über den TESTER_BIDIR Pin 23b auf Eingang geschaltet. Die Eingangs-FFs 7a, 7b, 7d befinden sich im Normalbetrieb, d.h. im Parallelbetrieb. Am ASIC 1 wird für einen Takt das Testvektormuster an allen Eingangspins 3a, 3b, 3c angelegt, und nachdem die Daten in die Eingangs-FFs 7a, 7b, 7d übernommen wurden, wird über den SCAN_ENABLE Pin 18 mit Hilfe der Multiplexer 16 der Schiebemodus hergestellt und die Daten seriell aus dem ASIC 1 ausgeschoben, so daß die Daten auswertbar sind.

Dieser Vorgang wird nun wiederholt, doch wird der Schritt des Anlegens des Testeingangsmusters an alle Eingangspins 3 zeitlich relativ zur Taktung variiert. Wenn die ausgewerteten Daten Fehler aufweisen, ist dies ein Indiz für eine Verletzung des SETUP- und HOLD-Zeitenkriteriums des oder der Eingangs-FFs. Somit kann die SETUP- und HOLD-Zeit indirekt bestimmt werden, da eine Verletzung des Timings bei den Eingängen durch Fehlausgaben an den Ausgängen des ASICs 1 signalisiert werden.

Zusammenfassend kann festgestellt werden, daß die vorliegende Erfindung ein elektronisches Bauteil und ein Verfahren für eine verbesserte Timingmessung bei integrierten Schaltkreisen vorsieht. Der neue Baustein und das neue Verfahren beruhen auf einer geringfügigen hardwaremäßigen Vorleistungen im ASIC, was im Allgemeinen auch Design for Test (DFT) bezeichnet wird. Das oben beschriebene Verfahren und Vorrichtung bietet folgende Vorteile:
- Es müssen lediglich verhältnismäßig kurze Testvektoren für die Timingmessung eingesetzt werden.
- Es ergeben sich kurze Testzeiten unabhängig von der logischen Tiefe des zu testenden ASICs 1.
- Die Testvektoren können aus einer dem Boundery Scan Discription Language File (BSDL-File) ähnlichen Datenbasis automatisch erzeugt werden.
- Die Timingmessungen können durchgeführt werden, ohne den Central-Core 11 in Betrieb nehmen zu müssen.
- Der für die Messung wichtige Taktbaum 13 und die PLLs werden in den Timingmessungen berücksichtigt, d.h. bei den Timingmessungen liegt eine reale Taktung vor.
- Meßteams müssen sich weit weniger als bisher mit der Funktion des ASICs 1 auseinandersetzen, daher wird der Vorbereitungsaufwand für Timingmessungen erheblich reduziert.
- Es besteht ein nur geringfügiger Aufwand in der Hardware.

Die vorliegende Erfindung ist insbesondere auch im Zusammenhang mit der am selben Tag hinterlegten Anmeldung ....................... derselben Anmelderin mit dem Titel "Elektronischer Baustein" einsetzbar, wobei zur Vermeidung von Wiederholungen der Gegenstand dieser Anmeldung auch zum Inhalt der vorliegenden Anmeldung gemacht wird.

## Patentansprüche

1. Elektronischer Baustein (1) mit integrierter Halbleiterschaltung, die einen Core (2) mit funktionalen Flip-Flops aufweist, wobei ein Teil der funktionalen Flip-Flops als Eingangs-FFs (7) mit Eingangspins (3) des Bausteins (1) und ein Teil der funktionalen Flip-Flops als Ausgangs-FFs (8) mit Ausgangspins (6) des Bausteins (1) verbunden sind,
**dadurch gekennzeichnet,**
**daß** die Eingangs-FFs (7) und die Ausgangs-FFs (8) während einer Qualifizierungsmessung des Bausteins (1) zu einem Schieberegister zusammenschaltbar sind.

2. Baustein nach Anspruch 1,
**dadurch gekennzeichnet,**
**daß** die Eingangs-FFs (7) und die Ausgangs-FFs (8) jeweils an ihren Eingängen ein Schaltelement (16) aufweisen und mittels dieses Schaltelementes (16) durch Ansteuerung über eine für alle Schaltelemente (16) zentrale Steuerung (28) zusammenschaltbar sind.

3. Baustein nach Anspruch 1,
**dadurch gekennzeichnet,**
**daß** die Eingangs-FFs (7) und die Ausgangs-FFs (8) jeweils über Eingangsbuffer mit den Eingangspins (3) bzw. über Ausgangsbuffer mit den Ausgangspins (6) des Bausteins (1) verbunden sind.

4. Baustein nach Anspruch 1 oder 2,
**dadurch gekennzeichnet,**
**daß** die Qualifizierungsmessung eine Setup- und/oder eine Hold-Messung an den Eingangs-FFs (7) ist.

5. Baustein nach einem der vorhergehenden Ansprüche,
**dadurch gekennzeichnet,**
**daß** die Qualifizierungsmessung eine Clock-to-output-Zeitmessung an den Ausgangs-FFs (8) und/oder den Ausgängen des Bausteins (1) ist.

6. Baustein nach einem der vorhergehende Ansprüche,
**dadurch gekennzeichnet,**
**daß** die Qualifizierungsmessung eine Enable-to-output-Zeitmessung an den Ausgangs-FFs (8) und/oder den Ausgängen des Bausteins (1) ist.

7. Baustein nach einem der vorhergehende Ansprüche,
**dadurch gekennzeichnet,**
**daß** die Schaltelemente (16) Multiplexer sind.

8. Baustein nach einem der vorhergehende Ansprüche,
**dadurch gekennzeichnet,**
**daß** das jeweilige Schaltelement (16) bei der Qualifizierungsmessung den Ausgang eines Eingangs-FFs (7a) bzw. Ausgangs-FFs (8a) mit dem Eingang eines benachbarten Eingangs-FFs (7b) bzw. Output-FF (8b) verbindet.

9. Baustein nach einem der vorhergehende Ansprüche,
**dadurch gekennzeichnet,**
**daß** alle Eingangs- und Ausgangs-FFs (7,8) über einen Taktbaum (13) die selbe Taktung erhalten.

10. Baustein nach einem der vorhergehende Ansprüche,
**dadurch gekennzeichnet,**
**daß** die Eingangs- und/oder Ausgangs-FFs (7,8) über einen Taktbaum (13) eine unterschiedliche Taktung erhalten.

11. Baustein nach einem der vorhergehende Ansprüche,
**dadurch gekennzeichnet,**
**daß** die Steuerung einen ersten Pin (18) zur Steuerung der Schaltelemente (16), einen zweiten Pin (23) zur Ansteuerung der unidirektionalen Outputpuffer und einen dritten Pin (25) zur Steuerung der bidirektionalen Outputpuffer hat.

12. Baustein nach einem der vorhergehende Ansprüche,
**dadurch gekennzeichnet,**
**daß** die Steuerung eine Vielzahl von Gattern (25, 26, 27) aufweist.

13. Verfahren zur Qualifizierungsmessung eines elektrischen Bausteins (1) mit einer Integrierten Halbleiterschaltung, die einen Core (2) mit funktionalen Flip-Flops aufweist, wobei ein Teil der funktionalen Flip-Flops als Eingangs-FFs (7) mit Eingangspins (3) des Bausteins (1) und ein Teil der funktionalen Flip-Flops als Ausgangs-FFs (8) mit Ausgangspins (6) des Bausteins (1) verbunden sind, **dadurch gekennzeichnet,**
**daß** die Eingangs-FFs (7) und die Ausgangs-FFs (8) während einer Qualifizierungsmessung des Bausteins (1) zu einem Schieberegister zusammengeschaltet werden.

14. Verfahren nach einem der vorhergehende Ansprüche,
**dadurch gekennzeichnet,**
**daß** die Eingangs-FFs (7) und die Ausgangs-FFs (8) jeweils an ihren Eingängen ein Schaltelement (16) aufweisen, und mittels dieses Schaltelementes (16) durch Ansteuerung über eine für alle Schaltelemente (16) zentrale Steuerung (18) zusammengeschaltet werden.

15. Verfahren nach einem der vorhergehende Ansprüche,
**dadurch gekennzeichnet,**
**daß** als Qualifizierungsmessung eine Setup- und Hold-Messung der Eingangs-FFs durchgeführt wird.

16. Verfahren nach einem der vorhergehende Ansprüche,
**dadurch gekennzeichnet,**
- **daß** zunächst die Testdaten über Eingänge des Bauelements parallel in die Eingangs-FF (7) eingegeben werden,
- **daß** danach die Steuerung (18) die Eingangs-FFs (7) und die Ausgangs-FFs (8) zum Schieberegister zusammengeschaltet werden,
- **daß** danach die Testdaten seriell das Schieberegister durchlaufen und über einen Ausgang ausgelesen werden.

17. Verfahren nach einem der vorhergehende Ansprüche,
**dadurch gekennzeichnet,**
**daß** durch zeitliche Variation der Dateneingabe in die Eingangs-FF (7) relativ zur Taktung und durch Verifizierung der ausgelesenen Testdaten die Setup- und Holdzeit bestimmt wird.

18. Verfahren nach einem der vorhergehende Ansprüche,
**dadurch gekennzeichnet,**
**daß** als Qualifizierungsmessung eine Clock-to-output-Zeitmessung der Ausgangs-FFs (8) durchgeführt wird.

19. Verfahren nach einem der vorhergehende Ansprüche,
**dadurch gekennzeichnet,**
- **daß** die Steuerung (28) die Eingangs-FFs (7) und die Ausgangs-FFs (8) zu einem Schieberegister schaltet,
- **daß** die Testdaten über einen Eingang des Bauelements seriell in ein Eingangs-FF eingeschoben werden,
- **daß** die Testdaten das Schieberegisters seriell durchlaufen,
- **daß** während des Einschiebevorgangs der Daten in die Ausgangs-FFs (8) die Clock-to-output-Zeiten an den Ausgängen der Ausgangs-FF(8) und/oder an den Ausgangspins (6) gemessen werden.

20. Verfahren nach einem der vorhergehende Ansprüche,
**dadurch gekennzeichnet,**
- **daß** die Testdaten über die Eingänge des Bauelements parallel in die Eingangs-FF (7) eingeschoben werden,
- **daß** die Steuerung (28) die Eingangs-FF (7) und die Ausgangs-FF (8) zu einem Schieberegister schaltet,
- **daß** die Testdaten seriell durch ein Durchlaufen des Schieberegisters in die Ausgangs-FF (8) gelangen, und während des Einschiebevorgangs der Daten in die Ausgangs-FFs (8) an den entsprechenden Ausgängen des Bauteils (1) die Clock-to-output-Zeiten gemessen werden.

21. Verfahren nach einem der vorhergehende Ansprüche,
**dadurch gekennzeichnet,**
**daß** die Qualifizierungsmessung eine Enable-to-output-Zeitmessung der Ausgangs-FFs (8) ist.

22. Verfahren nach einem der vorhergehende Ansprüche,
**dadurch gekennzeichnet,**
**daß** bei der Enable-to-output-Zeitmessung der Ausgangs-FFs (8) ein Tristate-Buffer durch ein Flip-Flop (8d) des Schieberegisters gesteuert wird, wobei die in das Schieberegister seriell eingeschobenen Testvektordaten zur Steuerung dienen.
